Europäisches Patentamt

European Patent Office

Office européen des brevets

(11) Publication number: **0 490 273 A2**

## EUROPEAN PATENT APPLICATION

(21) Application number: **91120907.0**

(22) Date of filing: **05.12.91**

(51) Int. Cl.5: **H04L 7/00**, H04L 7/033

(30) Priority: **10.12.90 JP 400263/90**

(43) Date of publication of application:
**17.06.92 Bulletin 92/25**

(84) Designated Contracting States:
**DE FR GB**

(71) Applicant: **ADVANTEST CORPORATION**
**32-1, Asahi-cho 1-chome**
**Nerima-Ku Tokyo(JP)**

(72) Inventor: **Higuchi, Kenji**
**3-13-16, Nishi**
**Hanyu-shi, Saitama(JP)**

(74) Representative: **Blumbach Weser Bergen**
**Kramer Zwirner Hoffmann Patentanwälte**
**Radeckestrasse 43**
**W-8000 München 60(DE)**

(54) **Retiming circuit.**

(57) Input data (D) is retimed by a first one of the D-type flip-flops (12, 21) using a clock (CK), and at the same time, the input data is delayed by a delay element (22) and the delayed output (D') is retimed by the second D-type flip-flop (21). The outputs (Q1, Q2) of the first and second D-type flip-flops are compared by a comparator (23), and when the timing of the clock relative to the input data is inappropriate, the comparator yields a signal indicating non-coincidence between the both outputs.

FIG. 3

EP 0 490 273 A2

## BACKGROUND OF THE INVENTION

The present invention relates to a retiming circuit which is used in, for example, an input part of a bit error rate detector, for retiming input data by a D-type flip-flop through use of a clock of the same period as that of the input data.

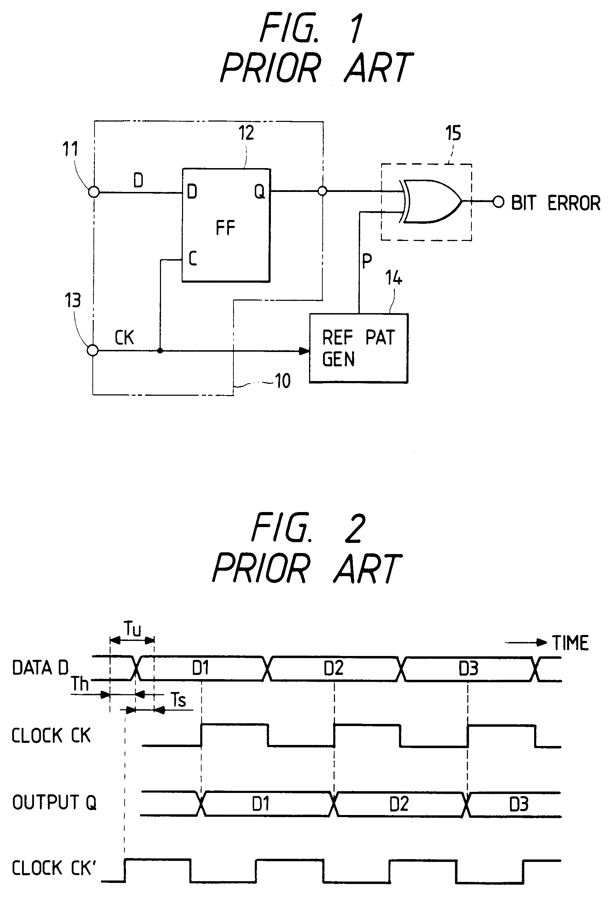

Fig. 1 shows a conventional retiming circuit indicated generally by 10. Input data D from an input terminal 11 is provided to a data terminal D of a D-type flip-flop 12 forming the retiming circuit 10. A clock CK of the same frequency as that of the input data is applied to a clock terminal CK of the D-type flip-flop 12 from an input terminal 13 and the input data is fetched into the flip-flop 12 by positive-going edges on the clock CK, for instance.

In this way, for example, as shown in Fig. 2, pieces of input data D1, D2, D3, ... are retimed by the clock CK to obtain at the Q output of the flip-flop 12 the data D1, D2, D3, ... synchronized with the clock CK. In the case where the retiming circuit 10 is employed in a bit error rate detector, a reference pattern P is generated by a reference pattern generator 14 in synchronization with the clock CK from the terminal 13 and is provided to a pattern comparator 15, wherein it is compared with the Q output from the flip-flop 12. When the input data has no error, the output of the pattern comparator 15 is a logic "0" but if the input data has a bit error, then the output of the pattern comparator 15 goes to a logic "1" at that bit.

The vicinity of the boundary between pieces of input data is indefinite during the setup time Ts and the hold time Th of a logic circuit, and if the rise-up point of the clock CK coincides with the indefinite portion Tu as shown in the row of a clock CK' in Fig. 2, then the input data cannot be retimed correctly, in which case even if the input data has no error, the Q output from the D-type flip-flop 12 may not match the reference pattern P. Thus, it is impossible to distinguish between a bit error and an error by an inappropriate phase relation between the input data and the clock, based only on the output of the pattern comparator 15.

## SUMMARY OF THE INVENTION

It is therefore an object of the present invention to provide a retiming circuit which permits the detection of inappropriate timing of a clock relative to input data.

According to the present invention, a second D-type flip-flop is provided in the conventional retiming circuit including the first D-type flip-flop, and also in the second D-type flip-flop, the same input data is retimed by the same clock. The outputs from the first and second D-type flip-flops are compared by a comparator and its non-coincidence output indicates that the timing of the clock is inappropriate relative to the input data.

In the above-mentioned retiming circuit the input data to the second D-type flip-flop may also be delayed by a delay element behind the input data to the first D-type flip-flop.

Alternatively, it is possible that in the above retimig circuit the clock to the second D-type flip-flop and the output from the first D-type flip-flop to the comparator are delayed behind the clock to the first D-type flip-flop, by first and second delay elements of substantially the same delay time, respectively.

## BRIEF DESCRIPTION OF THE DRAWINGS

Fig. 1 is a block diagram showing a conventional retiming circuit;
Fig. 2 is a time chart showing the operation of the prior art example depicted in Fig. 1;
Fig. 3 is a block diagram illustrating an embodiment of the present invention;
Fig. 4 is a time chart showing an example of the operation of the Fig. 3 embodiment;
Fig. 5 is a block diagram illustrating another embodiment of the present invention;
Fig. 6 is a block diagram illustrating still another embodiment of the present invention; and
Fig. 7 is a block diagram illustrating still a further embodiment of the present invention equipped with an automatic clock phase control function and applied to an error detector.

## DESCRIPTION OF THE PREFERRED EMBODIMENTS

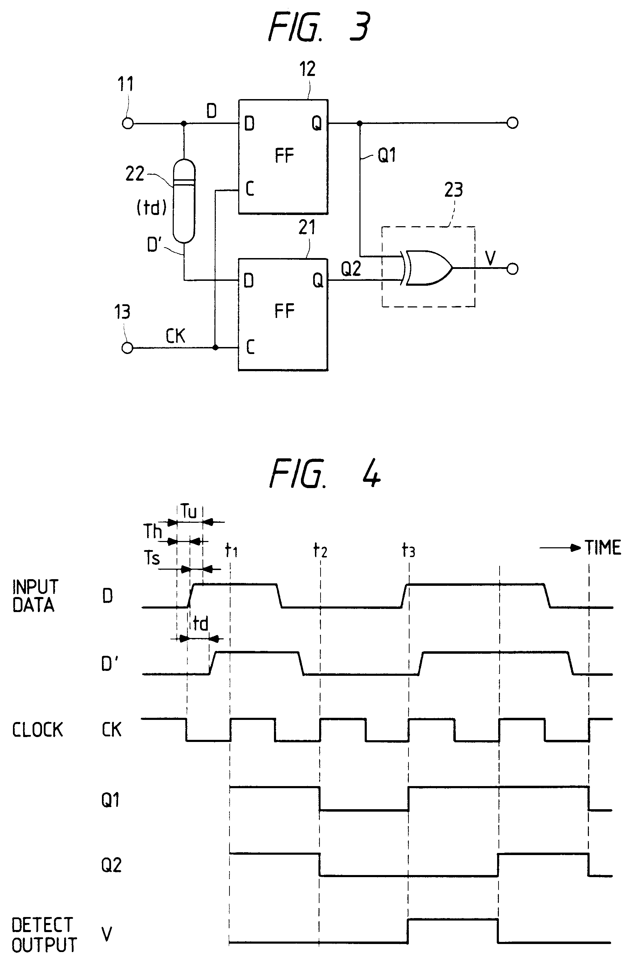

Referring now to Fig. 3, a first embodiment of the present invention will be described. In Fig. 3 the parts corresponding to those in Fig. 1 are identified by the same reference numerals. According to the present invention, another D-type flip-flop 21 is provided in the conventional retiming circuit. The input data D from the terminal 11 is applied to a data terminal D of the D-type flip-flop 21 after being delayed by a delay element 22 and the clock CK is applied directly to a clock terminal C of the D-type flip-flop 21. Consequently, in the D-type flip-flop 21 the input data D' delayed by the delay element 22 is retimed by the clock CK from the terminal 13. The output Q1 from the flip-flop 12 and the output Q2 from the flip-flop 21 are compared by a comparator 23.

In the above circuit arrangement, for example, as shown in Fig. 4, the input data D is provided to the terminal 11 and the data D', delayed by the delay element 22 for a time td relative to the input data D, is provided to the flip-flop 21. In the case where the clock CK at the terminal 13 rises at time

points $t_1$ and $t_2$ apart from changing points of the pieces of data D and D' and they match, the outputs Q1 and Q2 of the flip-flops 12 and 21 are the same and the output V of the comparator 23 is at the low level "0." When the clock CK rises at a time point $t_3$ near the changing points of the pieces of data D and D', however, the data D is fetched into the flip-flop 12 after its changing point and is high-level but the data D' is fetched into the flip-flop 21 prior to its changing point and is low-level. In this instance, the outputs Q1 and Q2 of the flip-flops 12 and 21 do not match and the output V of the comparator 23 goes to a "1."

Thus, it is detected that when the output V of the comparator 23 is at the low level, the timing (i.e. phase) of the clock CK relative to the input data D is appropriate and that when the output V of the comparator 23 is at the high level, the timing of the clock CK relative to the input data D is inappropriate. An increase in the delay td of the delay element 22 increases the range over which the timing of the clock CK is judged to be inappropriate, and consequently, decreases the range over which the timing of the clock CK is judged to be appropriate. It is preferable that the sum Tu of the setup time Ts and the hold time Th of the flip-flop 12 be substantially equal to that of the flip-flop 21 and that the sum Tu and the delay time td be substantially equal to each other. A decrease in the delay time td will impair the accuracy of detection of the inappropriate timing of the clock CK, but in the case where the occurrence of inappropriate timing of the clock CK may be overlooked to some extent, the delay time td may be selected short.

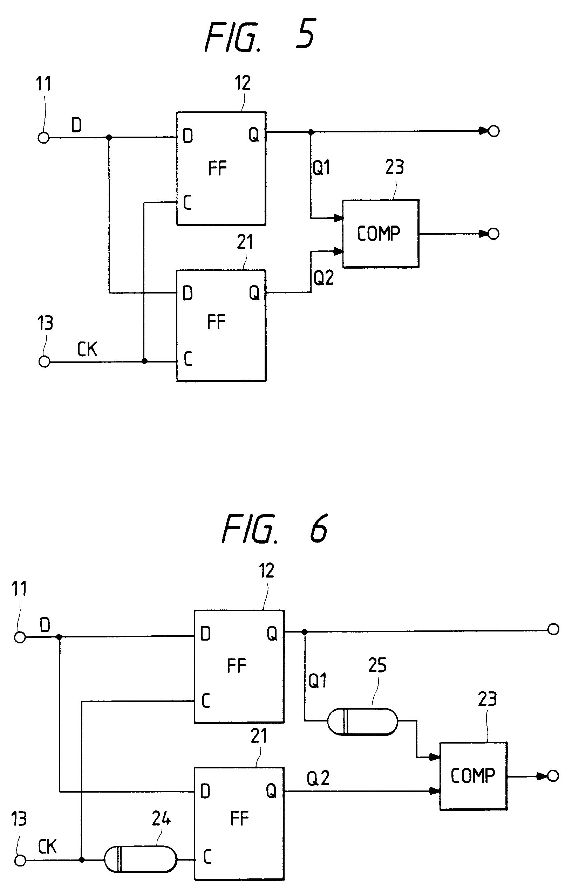

An extreme example is the case where the delay time td is zero, as exemplified in Fig. 5. In this embodiment the delay element 22 in Fig. 3 is left out and the terminal 11 is connected directly to the data terminal D of the flip-flop 21. In general, the setup time Ts and the hold time Th of D-type flip-flops somewhat scatter, and when the D-type flip-flop is triggered by a clock, its output is not fixed to the low-level "0" or high-level "1" if the changing point of input data lies between -Th and +Ts. Accordingly, even if the input data is provided to the D-type flip-flops 12 and 21 at exactly the same timing, the both flip-flops 12 and 22 do not always provide the same output when the rise of the clock CK bears a phase relationship between -Th and +Ts relative to the changing point of the input data. That is, due to the difference in performance between the individual D-type flip-flops 12 and 22 and noise superimposed on the input data, the flip-flops 12 and 22 produce different outputs once in a while and the output of the comparator 23 goes high, thus it is detected that the timing of the clock CK is inappropriate relative to the input data D.

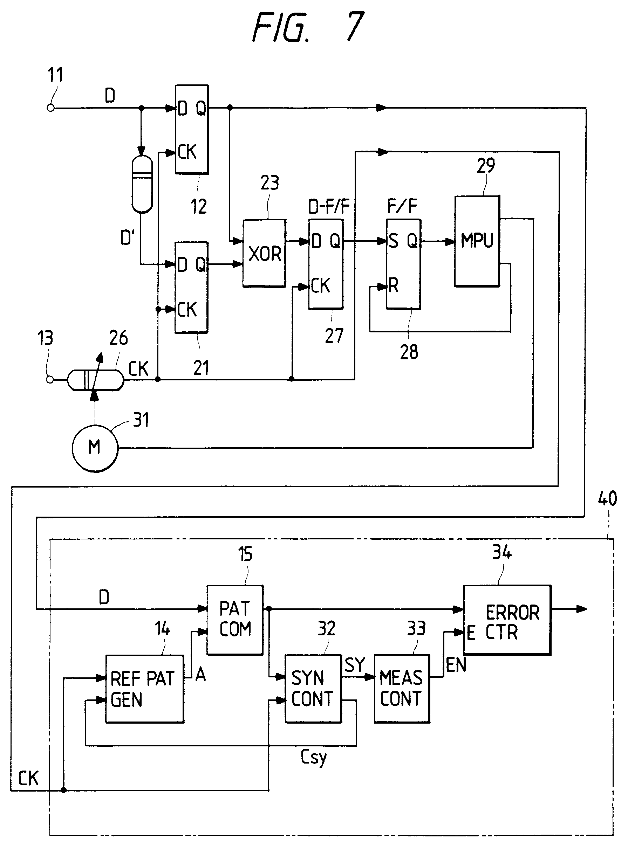

Fig. 6 illustrates another embodiment of the present invention, in which the parts corresponding to those in Fig. 3 are identified by the same reference numerals. In this embodiment the flip-flops 12 and 22 are simultaneously supplied with the input data D but the clock CK is applied to the flip-flop 21 after being delayed $td_1$, by a delay element 24, behind the clock CK to the flip-flop 12. The output Q2 of the flip-flop 21 is applied directly to the comparator 23 but the output Q1 of the flip-flop 12 is delayed $td_2$ by a delay element 25 and is then applied to the comparator 23. In this case, the delay times $td_1$ and $td_2$ are selected substantially equal to each other.

With the above arrangement, the retimed output Q2 of the flip-flop 21 lags behind the retimed output Q1 of the flip-flop 12 by $td_1$, but the latter is compared with the former after being delayed by $td_2$; so that if the timing of the clock CK at the terminal 13 is inappropriate relative to the input data at the terminal 11, the comparator 23 yields a non-coincidence output.

In each of the embodiments shown in Figs. 3, 5 and 6, when the inappropriate timing has been detected by the comparator 23, the detection signal is used, for example, to turn ON an indicator not shown, and reading the "ON" display on the indicator, an operator manually controls a variable delay line (not shown) to control the phase of the clock CK to be applied to the terminal 13 so that the indicator is eventually turned OFF. The control of the variable delay line may also be automatically effected.

Fig. 7 shows the case where the Fig. 3 embodiment is applied to a bit error detector as is the case with the prior art example of Fig. 1 and the phase of the clock CK is automatically controlled by the inappropriate timing detection signal. The D-type flip-flops 12 and 21 for retiming use are supplied with the clock CK delayed by a variable delay line 26. The compared output from the comparator 23 is stably fetched into a D-type flip-flop 27 by use of the next clock CK. A set/reset-type flip-flop 28 is set by an output logic "1" of the D-type flip-flop 27 and the output of the flip-flop 28 is applied to a microprocessor 29.

When the output of the flip-flop 28 is a logic "1," the microprocessor 29 drives a motor 31 by a fixed amount to thereby increase (or decrease) the delay of the variable delay line 26 by a predetermined amount $\Delta d$ and, at the same time, resets the flip-flop 28. When the comparator 23 has provided again a "1" (the inappropriate timing detection signal) after the above delay adjustment operation, the delay of the variable delay line 26 is increased again by $\Delta d$ and the flip-flop 28 is reset in the same manner as described above. In this way, the variable delay line 26 is repeatedly adjusted until no inappropriate timing detection signal is provided from the comparator 23.

The retimed input data D from the F-type flip-flop 12 is applied to the pattern comparator 15 of an error detector 40. On the other hand, the reference pattern generator 14 generates a reference pattern A in synchronization with the phase-adjusted clock CK and applies it to the pattern comparator 15. The pattern comparator 15 compares the reference pattern A and the data D on a bitwise basis and, in the case of non-coincidence, outputs a "1" as a bit error detection signal. The number of such bit error detection signals is counted by an error counter 34, from which an error count value is output at regular time intervals.

The bit error detection signal is applied to a synchronization control circuit 32 as well. When the error rate is in excess of a certain value, it is decided that the reference pattern A and the data D are not synchronized with each other, and the synchronization control circuit 32 applied a synchronization control signal Csy to the reference pattern generator 14. When supplied with the synchronization control signal Csy, the reference pattern generator 14 delays, for example, by one bit, the phase of the reference pattern A to be generated. When the error data has become smaller than a certain value in the synchronization control circuit 32, a synchronization establishment signal SY is applied from the circuit 32 to a measurement control circuit 33. The measurement control circuit 33 responds to the synchronization establishment signal SY to supply the error counter 34 with a counting enable signal EN which causes it to count errors for a fixed period of time. While being supplied with the enable signal EN, the error counter 34 counts errors.

As described above, according to the present invention, inappropriate timing of a clock relative to input data can be detected in a retiming circuit. Hence, when inappropriate timing has been detected, the phase of the clock can be adjusted to provide appropriate timing for correct retiming. By applying the present invention to an input part of an error rate detector, it is possible to distinguish between a true bit error and an error caused by inappropriate timing of the clock used.

It will be apparent that many modifications and variations may be effected without departing from the scope of the novel concepts of the present invention.

## Claims

1. A retiming circuit comprising:
    a first D-type flip-flop for retiming input data by a clock;
    a second D-type flip-flop supplied with said input data, for retiming it by said clock; and
    a comparator which compares the outputs from both of said first and second D-type flip-flops and, in the case of non-coincidence, outputs a detection signal representing that the timing of said clock is inappropriate relative to said input data.

2. The retiming circuit of claim 1, further comprising a delay element whereby said input data to said second F-type flip-flop is delayed behind said input data to said first D-type flip-flop.

3. The retiming circuit of claim 2, wherein the delay of said delay element is substantially equal to the sum of a setup time and a hold time of said first and second D-type flip-flops.

4. The retiming circuit of claim 1, further comprising a first delay element whereby said clock to be supplied to said second D-type flip-flop is delayed behind said clock to said first D-type flip-flop, and a second delay element whereby the output from said first D-type flip-flop to said comparator is delayed for about the same period of time as the delay time of said first delay element.

5. The retiming circuit of 1, 2, or 4, further comprising variable delay means for changing the phase of said clock to be applied to said first and second D-type flip-flops, and delay control means responsive to said detection signal from said comparator to control said variable delay means.

# FIG. 1
# PRIOR ART

# FIG. 2
# PRIOR ART

## FIG. 3

## FIG. 4

## FIG. 5

## FIG. 6

# FIG. 7